# EUROPÄISCHE PATENTANMELDUNG

(11) **EP 3 839 309 A1**
(43) Veröffentlichungstag der Anmeldung: **23.06.2021**
(21) Anmeldenummer: 20214497.8
(22) Anmeldetag: 16.12.2020
(51) Int. Cl.: F16K 31/06, F04B 39/08

(54) **ELEKTROMAGNETISCHER AKTUATOR**

(30) Priorität: 18.12.2019 AT 511132019
(71) Anmelder: Hoerbiger Wien GmbH, 1220 Wien (AT)
(72) Erfinder: Bischelmeier, Gernot, 1020 Wien (AT); Kornfeld, Matthias, 2345 Brunn/Geb. (AT); Spiegl, Bernhard, 1210 Wien (AT)
(74) Vertreter: Patentanwälte Pinter & Weiss OG

(57) **Zusammenfassung**

Um einen elektromagnetischen Aktuator (1) zur Ventilbetätigung eines Kolbenkompressors (19) anzugeben, der möglichst einfach und kompakt aufgebaut ist und der gleichzeitig hohe Anforderungen hinsichtlich Effizienz, Wartungsarmut, Zuverlässigkeit und Langlebigkeit erfüllt, ist erfindungsgemäß vorgesehen, dass die Leistungselektronik (6) des Aktuators (1) im Aktuatorgehäuse (2) zwischen der Spule (3) und einem axialen Aktuatorende (E) des Aktuators (1), an dem eine Betätigungsöffnung (5a) für ein Betätigungselement (5) vorgesehen ist, angeordnet ist, wobei die Leistungselektronik (6) durch eine Gehäusewandung (7) des Aktuatorgehäuses (2) von der Spule (3) getrennt ist, wobei eine Leiterplatte (8) der Leistungselektronik (6) an einer an der Gehäusewandung (7) vorgesehenen Befestigungsfläche (9) angeordnet ist, wobei sich elektrische Spulenkontakte (10) der Spule (3) durch die Gehäusewandung (7) hindurch erstrecken und mit der Leiterplatte (8) verbunden sind.

## Beschreibung

Die Erfindung betrifft einen elektromagnetisch betätigbaren Aktuator zur Anordnung an einem Kolbenkompressor, zur Betätigung eines Ventils des Kolbenkompressors, wobei der Aktuator ein Aktuatorgehäuse aufweist, in dem eine Spule und ein Magnetanker angeordnet sind, wobei der Magnetanker mit der Spule elektromagnetisch zusammenwirkt, um den Magnetanker zu bewegen, wobei der Magnetanker mit einem Betätigungselement zur Betätigung des Ventils verbunden ist, wobei an einem axialen Aktuatorende des Aktuatorgehäuses eine Betätigungsöffnung für das Betätigungselement vorgesehen ist und wobei der Aktuator von einer Leistungselektronik ansteuerbar ist. Weiters betrifft die Erfindung einen Kolbenkompressor mit zumindest einem Ventil zur Steuerung eines Medienstroms eines Kompressionsmediums und mit einem Aktuator zur Betätigung des Ventils sowie eine Ventilbaugruppe zur Anordnung an einem Kolbenkompressor, mit einem Aufnahmegehäuse, in dem ein Ventil angeordnet ist und mit einem am Aufnahmegehäuse befestigten Aktuator, zur Betätigung des Ventils.

Bei Kolbenkompressoren wurde bisher meist eine mechanische oder hydraulische Ventilsteuerung zur Steuerung der Ein- und Auslassventile verwendet. Eine solche mechanische oder hydraulische Ventilsteuerung ist jedoch relativ aufwändig, verschleißanfällig und daher teuer in der Herstellung und in der Wartung. Um eine möglichst einfache, wartungsarme und insbesondere flexible Ventilsteuerung zu ermöglichen kommen immer öfter elektromagnetische Aktuatoren bei der Ventilbetätigung zum Einsatz. An solche Aktuatoren, deren Aufbau und Wirkungsweise grundsätzlich im Stand der Technik bekannt ist, sind bei der Verwendung zur Ventilbetätigung allerdings sehr hohe Anforderungen gestellt. Insbesondere soll einerseits eine kurze Betätigungszeit und ein über einen möglichst großen Bereich genau einstellbarer und reproduzierbarer Ventilhub ermöglicht werden, andererseits soll gleichzeitig ein geringer Energieverbrauch, eine hohe Zuverlässigkeit, langer Lebensdauer sowie kompakte Bauform gewährleistet werden.

Besonders bei Großkompressoren, bei denen bei der Ventilsteuerung relativ große Massen bewegt werden müssen, stoßen die verfügbaren elektromagnetischen Aktuatoren aber in ihre Grenzen. Um die geforderten Randbedingungen zu erfüllen sind hier besonders leistungsstarke Spulen erforderlich, die in der Regel einen relativ großen Bauraum benötigen. Die Spulen werden im Betrieb dabei mit großen elektrischen Strömen belastet, wodurch eine relativ große Wärmeentwicklung resultiert. Die Temperaturen im Bereich der Spulen eines Aktuators können hierbei beispielsweise im Bereich >120°C liegen. Da die temperaturempfindliche Leistungselektronik zur Ansteuerung der Spulen des Aktuators für solche hohen Temperaturen nicht geeignet ist, wurde sie bisher möglichst weit von den Spulen entfernt angeordnet, beispielsweise in einem separaten Gehäuse, um die Umgebungstemperatur der Leistungselektronik auf ein verträgliches Maß zu reduzieren. Dadurch konnten zwar die empfindlichen elektronischen Bauteile vor zu hohen Temperaturen geschützt werden, allerdings wurde dadurch die Komplexität des gesamten Aktuators weiter erhöht, weil beispielsweise Leitungen zwischen dem externen Gehäuse und dem Aktuator notwendig waren. Abgesehen davon vergrößert das natürlich den für den Aktuator erforderlichen Bauraum. Dies ist aber insbesondere bei Anwendungen nachteilig, bei denen der verfügbare Raum zur Anordnung der Aktuatoren inkl. Leitungen begrenzt ist.

Es ist daher die Aufgabe der Erfindung, einen elektromagnetischen Aktuator zur Ventilbetätigung eines Kolbenkompressors anzugeben, der möglichst einfach und kompakt aufgebaut ist und der gleichzeitig die hohen Anforderungen hinsichtlich Effizienz, Wartungsarmut, Zuverlässigkeit und Langlebigkeit erfüllt.

Die Aufgabe wird erfindungsgemäß dadurch gelöst, dass die Leistungselektronik im Aktuatorgehäuse zwischen der Spule und dem axialen Aktuatorende, an dem die Betätigungsöffnung vorgesehen ist, angeordnet ist, wobei die Leistungselektronik durch eine Gehäusewandung des Aktuatorgehäuses von der Spule getrennt ist, wobei eine Leiterplatte der Leistungselektronik an einer an der Gehäusewandung vorgesehenen Befestigungsfläche angeordnet ist, wobei sich elektrische Spulenkontakte der Spule durch die Gehäusewandung hindurch erstrecken und mit der Leiterplatte verbunden sind. Dadurch kann die Leistungselektronik thermisch günstig zwischen der Spule und dem axialen Aktuatorende angeordnet werden, wodurch eine verbesserte Abführung der von der Spule erzeugten Wärme erreicht wird. Die Wärme kann dadurch in vorteilhafter Weise vom Inneren des Aktuators über die Gehäusewandung an das Aktuatorgehäuse und über das axiale Aktuatorende beispielsweise an ein Kompressorgehäuse eines Kolbenkompressors abgeleitet werden.

Vorzugsweise ist das Aktuatorgehäuse zumindest im Bereich der Gehäusewandung aus einem wärmeleitfähigen Werkstoff, vorzugsweise Metall, besonders bevorzugt Aluminium hergestellt. Dadurch kann eine verbesserte Wärmeabfuhr durch die Gehäusewandung erreicht werden.

Um die Wärmeabfuhr von der Leistungselektronik an die Gehäusewandung weiter zu verbessern ist vorteilhaft, wenn zwischen der Befestigungsfläche der Gehäusewandung des Aktuatorgehäuses und der Leiterplatte zumindest ein Wärmeleitelement angeordnet ist.

Vorteilhafterweise ist das Wärmeleitelement mit der Leiterplatte verbunden, vorzugsweise mittels eines wärmeleitenden Klebstoffs oder wärmeleitenden Klebebands. Dadurch kann eine bessere Wärmeübertragung von der Leiterplatte an das Wärmeleitelement erreicht werden.

Wenn ein Wärmeleitelement vorgesehen ist, sind vorzugsweise zumindest temperaturempfindliche elektronische Bauelemente der Leiterplatte, insbesondere Mosfets, im Bereich des Wärmeleitelements angeordnet. Das ist vorteilhaft, um zumindest die empfindlichsten Bauteile zu schützen.

Weiters ist es vorteilhaft, wenn die Leistungselektronik zumindest teilweise mit einer wärmeleitfähigen Vergussmasse überzogen ist. Dadurch kann die Wärmeabfuhr von den elektronischen Bauteilen der Leistungselektronik weiter verbessert werden.

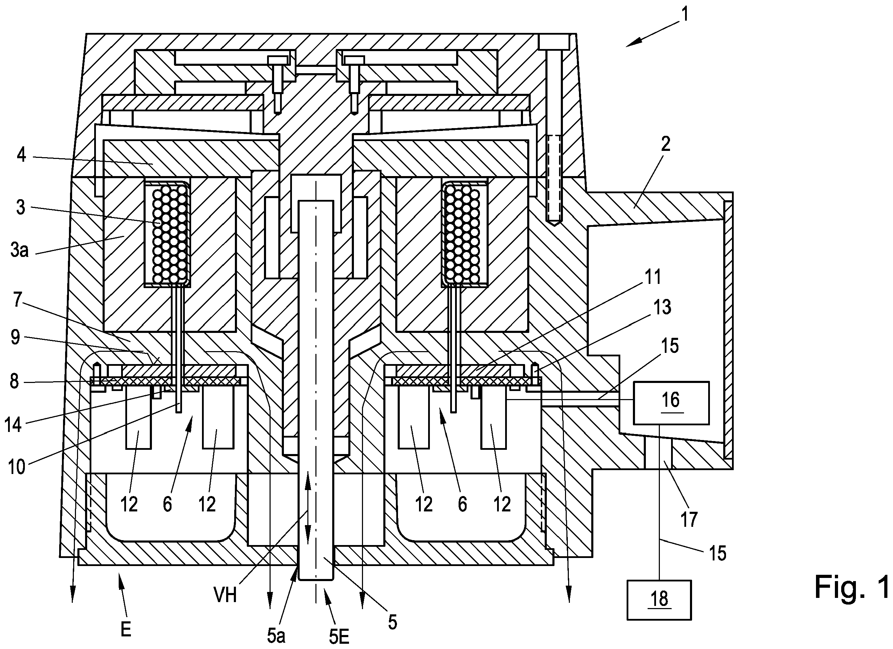

Der elektromagnetisch betätigbare Aktuator wird in bevorzugter Weise an einem Kolbenkompressor verwendet, um ein Ventil, vorzugsweise Saugventil, des Kolbenkompressors durch das Betätigungselement des Aktuators zu betätigen. Die gegenständliche Erfindung wird nachfolgend unter Bezugnahme auf Figuren 1 bis 2 näher erläutert, die beispielhaft, schematisch und nicht einschränkend eine vorteilhafte Ausgestaltung der Erfindung zeigt. Dabei zeigt
Fig.1 eine Schnittdarstellung des Aktuators in einer vorteilhaften Ausgestaltung,
Fig.2 eine Schnittdarstellung des Aktuators im montierten Zustand an einem Saugventil eines Kolbenkompressors.

In Fig.1 ist der erfindungsgemäße Aktuator 1 in einem Längsschnitt dargestellt. Der gezeigte Aktuator 1 weist ein Aktuatorgehäuse 2 auf, in dem zumindest eine Spule 3 und zumindest ein damit zusammenwirkender Magnetanker 4 angeordnet sind. Es können beispielsweise auch mehrere Spulen 3 um den Umfang gleichmäßig angeordnet sein oder die Spule 3 könnte mehrere Segmente aufweisen, die um den Umfang gleichmäßig angeordnet sind. Der Magnetanker 4 könnte dann in Umfangsrichtung mehrere mit den Spulen 3 oder den Spulensegmenten korrespondierende Ankersegmente aufweisen. Die konkrete konstruktive Ausgestaltung der Spule/n und des Magnetankers 4 ist für die Erfindung aber nicht wesentlich. Die Erfindung wird daher nachfolgend anhand einer Spule 3 und einem damit zusammenwirkenden Magnetanker 4 erläutert. Die Spule 3 und der Magnetanker 4 wirken elektromagnetisch zusammen, um den Magnetanker 4 axial zu bewegen. Dazu kann die Spule 3 mit elektrischer Spannung bzw. Strom versorgt werden, um ein Magnetfeld zu erzeugen, durch welches eine magnetische Anziehungskraft auf den Magnetanker 4 erzeugt werden kann. Durch die magnetische Anziehungskraft kann der Magnetanker 4 in Richtung der Spule 3 angezogen werden. Zur Rückstellung des Magnetankers 4 kann eine Rückstellfeder vorgesehen sein. Natürlich können auch mehrere Spulen 3 angeordnet sein, der Einfachheit halber wird im Folgenden aber Bezug auf eine Spule 3 genommen.

Der Bereich, in dem der Magnetanker 4 bewegt werden kann, wird als Ankerhub bezeichnet. Die Größe des Ankerhubs hängt im Wesentlichen von der konkreten konstruktiven Ausführung des Aktuators 1 ab, die sich wiederum nach dem Einsatzgebiet des Aktuators 1 richtet. Der Ankerhub kann beispielsweise im Bereich weniger Millimeter betragen. Die Spule 3 ist vorzugsweise in einem Eisenkern 3a mit möglichst hoher magnetischer Leitfähigkeit eingebettet oder umgibt einen solchen. Der Eisenkern 3a dient dazu, den von der Spule 3 erzeugten magnetischen Fluss zu bündeln und in den Magnetanker 4 zu leiten. Der Aufbau und die Wirkungsweise eines elektromagnetischen Aktuators sind grundsätzlich bekannt, weshalb an dieser Stelle nicht mehr näher darauf eingegangen wird.

Der Magnetanker 4 ist mit einem Betätigungselement 5 verbunden, das sich hier ausgehend vom Magnetanker 4 im Wesentlichen zentral axial durch den Aktuator 1 erstreckt. An einem axialen Aktuatorende E des Aktuatorgehäuses 2 ist eine Betätigungsöffnung 5a für das Betätigungselement 5 vorgesehen.

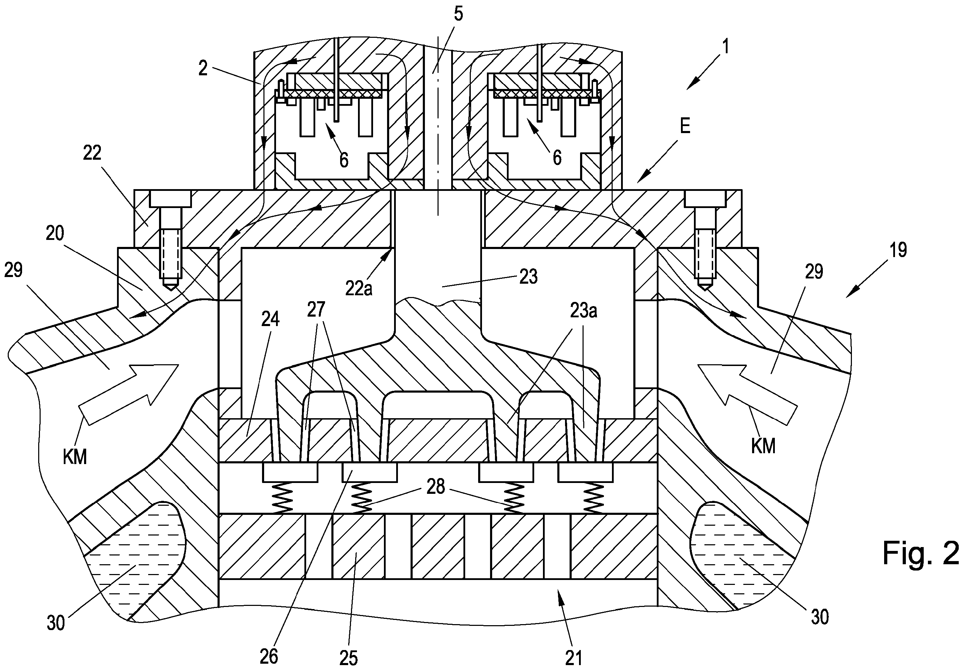

Das Betätigungselement 5 ist in der Betätigungsöffnung 5a axial verschiebbar, die Betätigungsöffnung 5a dient also im Wesentlichen zur Führung des Betätigungselements 5. Im dargestellten Beispiel steht ein Endabschnitt 5E des Betätigungselements 5 in axialer Richtung aus der Betätigungsöffnung 5a des Aktuatorgehäuses 2 hervor. Das ist aber nicht zwingend notwendig, sondern hängt im Wesentlichen von der konkreten konstruktiven Ausgestaltung des Aktuators 1 und des vorzugsweise damit zusammenwirkenden Betätigungsabschnitts des Ventils ab. Beispielsweise könnte der Endabschnitt 5E des Betätigungselements 5 auch innerhalb des Aktuatorgehäuses 2 liegen, wobei sich in der damit zusammenwirkende Betätigungsabschnitt des Ventils diesem Fall teilweise axial durch die Betätigungsöffnung 5a nach innen in das Aktuatorgehäuse 2 erstrecken würde. In jedem Fall ist aber eine Betätigungsöffnung 5a am axialen Aktuatorende E vorgesehen. Im montierten Zustand des Aktuators 1 an einem (in Fig.1 nicht dargestellten) Kolbenkompressor 19 ist das axiale Aktuatorende E des Aktuators 1 dem Kolbenkompressor 19 zugewandt (siehe Fig.2).

Das Betätigungselement 5 ist im dargestellten Beispiel im Wesentlichen ringförmig von der Spule 3 umschlossen. Das Betätigungselement 5 dient dazu, ein (nicht dargestelltes) Ventil zu betätigen, um das Ventil zu öffnen und/oder zu schließen. Dazu wird der Ankerhub über das Betätigungselement 5 auf das Ventil übertragen, wodurch sich ein sogenannter Ventilhub VH ergibt, wie in Fig.1 angedeutet ist. Der Ventilhub VH kann im einfachsten Fall dem Ankerhub entsprechen. Ggf. könnten aber auch Übertragungselemente zwischen Magnetanker 4 und Betätigungselement 5 vorgesehen sein, beispielsweise um ein gewisses Übersetzungsverhältnis zwischen Ankerhub und Ventilhub VH zu erzeugen. Dadurch könnte beispielsweise der Ventilhub VH relativ zum Ankerhub vergrößert werden und gleichzeitig die verfügbare Kraft zur Betätigung des Ventils verringert werden (oder umgekehrt). Bei der Betätigung des Aktuators 1 erfolgt also eine Relativbewegung zwischen dem Magnetanker 4 sowie des Betätigungselements 5 und dem Aktuatorgehäuse 2.

Um den Aktuator 1 zu betätigen, ist die Spule 3 von einer Leistungselektronik 6 elektrisch ansteuerbar. Unter der Leistungselektronik 6 sind jene Komponenten zu verstehen, die für die Energieversorgung der Spule 3 in geeigneter Form vorgesehen sind. Dazu zählt beispielswiese die Umwandlung und/oder Verstärkung von elektrischen Größen wie z.B. Strom, Spannung, Frequenz, etc., um die Spule 3 in gewünschter Weise anzusteuern. Die Leistungselektronik 6 weist dazu zumindest eine Leiterplatte 8 auf, auf der bestimmte elektronische Bauelemente 12 (Widerstände, Kondensatoren, Mosfets, etc.) angeordnet sind, die in geeigneter Weise mit der Leiterplatte 8 verbunden sind, beispielsweise verlötet, verklebt, gesteckt, etc. Wie eingangs erwähnt war die Leistungselektronik 6 bisher außerhalb des Aktuatorgehäuses 2 angeordnet, beispielsweise in einem separaten Gehäuse, und wurde über geeignete Leitungen mit dem Aktuatorgehäuse 2, insbesondere mit der darin angeordneten Spule 3 verbunden.

Dies war insbesondere dadurch bedingt, dass die auf der Leiterplatte 8 angeordneten elektronischen Bauelemente 12 in der Regel sehr temperaturempfindlich sind. Das kann einerseits bedeuten, dass manche elektronische Bauteile und/oder Lötverbindungen ab einer gewissen Temperatur beschädigt werden und dadurch ganz oder zumindest teilweise in ihrer Funktion eingeschränkt sind. Es bedeutet in der Regel aber auch, dass die Verluste mancher elektronischen Bauteile, wie z.B. Mosfets, mit steigender Temperatur überproportional zunehmen, was für einen energieeffizienten Betrieb des Aktuators 1 ebenfalls nachteilig ist. Insbesondere waren die Temperaturen innerhalb des Aktuatorgehäuses 2 aufgrund der von der Spule 3 abgegebenen Wärme bisher unzulässig hoch, sodass es zu Beschädigungen und/oder zu einer verminderten Funktionsfähigkeit der Leistungselektronik 6 und in Folge des gesamten Aktuators 1 geführt hätte. Speziell bei sicherheitsrelevanten Anwendungen, beispielsweise bei der Betätigung von Ventilen von Gaskompressoren, sind solche Einschränkungen inakzeptabel, weil hier hohe Anforderungen an die Dauerhaltbarkeit und Verfügbarkeit des Aktuators gegeben sind (z.B. genormte Anforderungen gemäß eines bestimmten safety integrity levels - "SIL"). Eine Anordnung der Leistungselektronik 6 innerhalb des Aktuatorgehäuses 2 wurde deshalb bisher vermieden.

Um die genannten Anforderungen trotzdem erfüllen zu können ist erfindungsgemäß vorgesehen, dass die Leistungselektronik 6 im Aktuatorgehäuse 2 zwischen der Spule 3 und dem axialen Aktuatorende E angeordnet ist und durch eine Gehäusewandung 7 des Aktuatorgehäuses 2 von der Spule 3 getrennt ist. Die Leiterplatte 8 der Leistungselektronik 6 ist dabei an einer an der Gehäusewandung 7 vorgesehenen Befestigungsfläche 9 angeordnet. Die elektrischen Spulenkontakte 10 der Spule 3 erstrecken sich durch die Gehäusewandung 7 hindurch und sind mit der Leiterplatte 8 verbunden, wie in Fig.1 ersichtlich ist. Dazu sind geeignete Öffnungen, wie z.B. Bohrungen in der Gehäusewandung 7 vorgesehen. Durch die Trennung mittels der Gehäusewandung 7 wird einerseits eine thermische Abschirmung der Leistungselektronik 6, insbesondere der darauf angeordneten elektronischen Bauelemente 12, von der Spule 3 geschaffen. Zudem wird durch eine thermisch günstige Positionierung der Leistungselektronik 6 zwischen der Spule 3 und dem axialen Aktuatorende E eine verbesserte Abführung der von der Spule 3 erzeugten Wärme erreicht. Die Wärme kann dadurch in vorteilhafter Weise vom Inneren des Aktuators 1 über die Gehäusewandung 7 an das Aktuatorgehäuse 2 und über das axiale Aktuatorende E an das Kompressorgehäuse 20 des Kolbenkompressors 19 abgeleitet werden (siehe Fig.2).

Die Energieversorgung der Leistungselektronik 6 sowie die Übertragung von Steuerungsbefehlen kann beispielsweise über eine geeignete elektrische Leitung 15 erfolgen, welche z.B. durch eine seitlich am Aktuator 1 vorgesehene Öffnung 17 geführt werden kann. Ggf. kann auch eine Aktuator-Steuerungseinheit 16 am Aktuator 1 vorgesehen sein, die Steuerungsbefehle von einer übergeordneten Steuerungseinheit 18, z.B. von einer Kompressorsteuerungseinheit, empfängt, verarbeitet und an die Leistungselektronik 6 überträgt. Die Leistungselektronik 6 könnte aber auch direkt von der übergeordneten Steuerungseinheit 18 angesteuert werden. In Abhängigkeit eines vorgegebenen Steuerungsprogramms kann/können die Steuerungseinheit/en 16, 18 den Aktuator 1 mit Steuerungsbefehlen zum Bewegen des Magnetankers 4 bzw. des Betätigungselements 5 ansteuern, beispielsweise zum Öffnen/Schließen eines Ventils eines Kompressors. Damit kann z.B. eine sehr flexible Mengenregelung eines Kompressors durchgeführt werden.

Vorzugsweise ist das Aktuatorgehäuse 2, zumindest im Bereich der Gehäusewandung 7, aus einem Werkstoff mit möglichst hoher Wärmeleitfähigkeit hergestellt, um eine möglichst gute Wärmeabfuhr zu erreichen. Vorteilhafte Werkstoffe sind geeignete Metalle wie z.B. Aluminium oder eine Aluminiumlegierung, natürlich wären aber auch andere Werkstoffe denkbar. Die Leiterplatte 8 ist mit einem geeigneten Befestigungsmittel 13 an der Befestigungsfläche 9 der Gehäusewandung 7 befestigt. Im dargestellten Beispiel sind als Befestigungsmittel 13 mehrere Schrauben vorgesehen, die in geeigneten Abständen am Umfang der Leiterplatte 8 verteilt angeordnet sind und mit dem Aktuatorgehäuse 2, insbesondere mit der Gehäusewandung 7 verschraubt sind. Natürlich wären aber auch andere Formen der Befestigung denkbar, beispielsweise eine geeignete Steckverbindung oder Klebeverbindung. Schrauben sind aber vorteilhaft, um eine leichtere Montage und Austauschbarkeit der Leistungselektronik 6 zu ermöglichen.

Wie in Fig.1 ersichtlich, erstrecken sich die Spulenkontakte 10 der Spule 3, hier axial, durch die Gehäusewandung 7 hindurch und sind auf der, der Spule gegenüberliegenden Seite der Gehäusewandung 7 (an der die Befestigungsfläche 9 vorgesehen ist) mit der Leiterplatte 8 verbunden. Um eine elektrisch leitfähige Verbindung zwischen den Spulenkontakten 10 und der Leiterplatte 8 herzustellen sind vorzugsweise geeignete Halteelemente 14 an der Leiterplatte 8 vorgesehen. Die Halteelemente 14 können beispielsweise form- oder reibschlüssige ausgeführt sein, z.B. in Form von im Stand der Technik bekannten Steck- oder Klemmverbindungen.

Um die Wärmeabfuhr des Aktuators 1 weiter zu verbessern ist es vorteilhaft, wenn zwischen der Befestigungsfläche 9 der Gehäusewandung 7 des Aktuatorgehäuses 2 und der Leiterplatte 8 zumindest ein Wärmeleitelement 11 angeordnet ist. Als Wärmeleitelement 11 kann beispielsweise eine Formplatte aus Aluminium oder aus einem anderen geeigneten Werkstoff mit guten Wärmeleiteigenschaften vorgesehen sein. Durch das Wärmeleitelement 11 wird die Wärmeübertragung zwischen der Leiterplatte 8 und der Gehäusewandung 7 verbessert. Besonders vorteilhaft ist es, wenn das Wärmeleitelement 11 mit der Leiterplatte 8 verbunden ist. Dadurch kann die gesamte Leistungselektronik 6 als bereits vormontiertes Bauteil im Aktuatorgehäuse 2 eingesetzt werden, wodurch die Montage des Aktuators 1 und insbesondere auch die Wartung erleichtert werden kann. Die Befestigung des Wärmeleitelements 11 an der Leiterplatte 8 erfolgt dabei vorzugsweise mittels eines wärmeleitenden Klebstoffs oder Klebebands, um die eine gute Wärmeübertragung zwischen der Leiterplatte 8 und dem Wärmeleitelement 11 zu gewährleisten. Im gezeigten Beispiel ist die Befestigungsfläche 9 an der Gehäusewandung 7 abgestuft aufgeführt, um ausreichend Raum für das Wärmeleitelement 11 zu schaffen.

Wenn ein Wärmeleitelement 11 vorgesehen ist, ist es weiters vorteilhaft, wenn zumindest temperaturempfindliche elektronische Bauelemente 12 der Leiterplatte 8 im Bereich des Wärmeleitelements 11 angeordnet sind. Insbesondere wenn nur ein begrenzter Platz zur Anordnung des Wärmeleitelements 11 verfügbar ist, kann es sein, dass nicht alle elektronischen Bauelemente 12 der Leiterplatte 8 im Bereich des Wärmeleitelements 11 Platz haben. Hier ist dann vorteilhaft, wenn zumindest jene Bauelemente 12, die besonders temperaturempfindlich sind, wie z.B. Mosfets, im Bereich des Wärmeleitelements 11 angeordnet werden. Um die verbesserte Wärmeleitung des Wärmeleitelements 11 möglichst gut auszunützen, sollten natürlich möglichst viele, vorzugsweise alle elektronischen Bauelemente 12 im Bereich des Wärmeleitelements 11 angeordnet sein.

Im gezeigten Beispiel in Fig.1 erstreckt sich das Wärmeleitelement 11 zur Veranschaulichung nicht bis ganz an den äußeren radialen Rand der Leiterplatte 8. Das Wärmeleitelement 11 ist hier also von der Stufe der Befestigungsfläche 9 durch einen Spalt radial beabstandet. Das bedeutet, dass die an der Leiterplatte 8 angeordneten elektronischen Bauteile, die (hier) unterhalb des Spalts liegen nicht von den verbesserten Wärmeleitfähigkeiten des Wärmeleitelements 11 profitieren. Vorteilhafterweise sollte das Wärmeleitelement 11 deshalb einen möglichst großen Bereich der Leiterplatte 8 abdecken. Besonders vorteilhaft ist es zudem, wenn die Leistungselektronik 6 zumindest teilweise mit einer (nicht dargestellten) wärmeleitfähigen Vergussmasse überzogen ist. Dadurch erfolgt eine verbesserte Wärmeübertragung von den elektronischen Bauteilen 12 (die mit der Vergussmasse überzogen sind) über die Leiterplatte 8 in die Gehäusewandung 7, ggf. über das Wärmeleitelement 11.

Der elektromagnetisch betätigbare Aktuator 1 ist bestimmungsgemäß zur Betätigung eines Ventils eines Kolbenkompressors 19 vorgesehen, insbesondere eines Saugventils 21 eines Kolbenkompressors 19, wie nachfolgend anhand von Fig.2 erläutert wird. Fig.2 zeigt dabei einen axialen Schnitt durch den Aktuator 1 im montierten Zustand am Kolbenkompressor 19. Der Aktuator 1 ist im gezeigten Beispiel Teil einer Ventilbaugruppe, welche als gesamte Einheit in einer dafür vorgesehenen Öffnung im Kompressorgehäuse 20 des Kolbenkompressors 19 angeordnet werden kann. Die Ventilbaugruppe weist ein Aufnahmegehäuse 22 (als Teil des Kompressorgehäuses 20), den Aktuator 1 sowie ein Ventil, hier das das Saugventil 21 auf. Der Aktuator 1 ist dabei am Aufnahmegehäuse 22 angeordnet, beispielsweise damit verschraubt oder in anderer geeigneter Weise daran befestigt. Das Aufnahmegehäuse 22 ist in der dafür vorgesehenen Öffnung im Kompressorgehäuse 20 des Kolbenkompressors 19 angeordnet und am Kompressorgehäuse 20 verschraubt ist, wie schematisch angedeutet. Das Ventil ist innerhalb des Aufnahmegehäuses 22 angeordnet. Zur Betätigung des Saugventils 21 betätigt das Betätigungselement 5 des Aktuators 1 im gezeigten Beispiel einen Abhebegreifer 23, der im Aufnahmegehäuse 22 des Saugventils 21 axial verschiebbar angeordnet ist. Um den Abhebegreifer 23 durch das Betätigungselement 5 betätigen zu können ist im Aufnahmegehäuse 22 eine Öffnung 22a vorgesehen. Ggf. kann auch ein dazwischengeschaltetes Kraftübertragungsglied, wie z.B. eine Schubstange vorgesehen sein. Der Aufbau und die Funktion eines Saugventils 21 mit Abhebegreifer 23 ist grundsätzlich bekannt, z.B. aus der AT 509 878 B1, weshalb die Funktionsweise nur anhand der wesentlichsten Komponenten beschrieben wird.

Das Saugventil 21 besteht in der Regel aus einem Ventilsitz 24 und einem Ventilfänger 25. Dazwischen ist ein Ventilelement 26 angeordnet, das zwischen Ventilsitz 24 und Ventilfänger 25 hin- und herbewegt werden kann. Das Ventilelement 26 kann im einfachsten Fall eine hinlänglich bekannte Ventilplatte sein. Das Ventilelement 26 wirkt mit dem Ventilsitz 24 zusammen, um die Dichtungsfunktion zu übernehmen, indem es ringförmige Durchgangskanäle 27 im Ventilsitz 24 verschließt und freigibt. Das Ventilelement 26 kann dazu von am Ventilfänger 25 angeordneten Federelementen 28 federbelastet sein. Die Federelemente 28 drücken somit das Ventilelement 26 gegen den Ventilsitz 24. Der Abhebegreifer 23 weist Abhebegreiferfinger 23a auf, die durch die Durchgangskanäle 27 des Ventilsitzes 24 hindurchgreifen und am Ventilelement 26 anliegen, um das Ventilelement 26 zu betätigen. Der Abhebegreifer 23 dient dabei beispielsweise dazu, den Kompressor lastlos hochzufahren bzw. den Kompressor 19 auf Leerlaufbetrieb zu schalten oder zur Mengenregelung des Kompressors 19.

Wenn der Aktuator 1, wie in Fig.2 angedeutet, an einem Kolbenkompressor 19 angeordnet ist, kann die von der Spule 3 des Aktuators 1 erzeugte Wärme vom Aktuatorgehäuse 2 an das Kompressorgehäuse 20 abgeleitet werden, wie in Fig.2 durch die Pfeile angedeutet ist. Im gezeigten Beispiel ist das Ventil als Saugventil 21 ausgebildet und in der Ventilbaugruppe angeordnet. Die Ventilbaugruppe umfasst dabei wie erwähnt das Saugventil 21 inkl. seiner oben genannten Komponenten sowie das Aufnahmegehäuse 22, in dem das Ventil 21 angeordnet ist und den Aktuator 1, der am Aufnahmegehäuse 22 befestigt ist. Im dargestellten Beispiel fließt die Wärme insbesondere vom Aktuatorgehäuse 2 über das Aufnahmegehäuse 22 der Ventilbaugruppe an das Kompressorgehäuse 20. In der Regel wird das Kompressorgehäuse 20 des Kompressors 19 im Bereich des Saugventils 21 von einem durch das Kompressorgehäuse 20 strömenden Kühlemedium gekühlt. Das Kühlmedium kann dabei im einfachsten Fall das angesaugte Kompressionsmedium KM (z.B. ein gasförmiges Medium wie Luft oder ein Prozessgas) selbst sein, wie in Fig.2 durch die Pfeile in den Ansaugkanälen 29 angedeutet ist. Es könnte aber zusätzlich auch ein separater Kühlkreislauf mit einem eigenen Kühlmedium vorgesehen sein, wie beispielsweise im Fall einer Wasserkühlung, wie durch den Wassermantel 30 angedeutet ist.

Die Spule 3 erreicht im Betrieb die höchsten Temperaturen, die typischerweise 120°C bis 130°C betragen kann. Die Leistungselektronik 6 ist im Vergleich eine untergeordnete Wärmequelle und erreicht im Betrieb Temperaturen von 100°C bis 110°C, insbesondere an üblicherweise verbauten Halbleiterschaltern wie MOSFETs. Die Bauteile der Leistungselektronik 6 haben eine zulässige maximale Betriebstemperatur, beispielsweise 125°C bei Hochtemperatur-Elektronikkomponenten. Alleine aus diesem Grund war es bisher nicht möglich, die Leistungselektronik 6 in der Nähe der Spule 3 anzuordnen, da die Gefahr besteht, dass die Elektronikkomponenten aufgrund der Temperatur der benachbarten Spule 3 überhitzen und beschädigt oder zerstört werden. Durch die erfindungsgemäße Anordnung der Leistungselektronik 6 kann aber der Kolbenompressor 19 selbst als Wärmesenke für den Aktuator 1 genutzt werden.

Durch die Kühlung des Kompressorgehäuses 20 stellen sich am Kompressorgehäuse 20 bzw. hier insbesondere am Aufnahmegehäuse 22 der Ventilbaugruppe, Temperaturen von typischerweise maximal 70°C ein. Durch diese niedrige Temperatur und die thermische Anbindung des Aktuators 1 an den Kompressor 19, stellt sich ein Temperaturgradient zwischen der Spule 3 und dem Kompressor 19 ein. Damit wird Wärme vom Aktuator 1 in Richtung des kühleren Kompressors 19 abgeführt und die Leistungselektronik 6 wird dadurch gekühlt. Erst dadurch ist es möglich, die Leistungselektronik 6 in der Nähe der Spule 3 und im Aktuatorgehäuse 2 des Aktuators 1 anzuordnen. Die Kühlung durch Konvektion an der Oberfläche des Aktuatorgehäuses 2 des Aktuators 1 würde dazu nicht ausreichen. Messungen an einem Aktuator 1 haben ergeben, dass durch die erfindungsgemäße Anordnung der Leistungselektronik 6 die maximale Temperatur im Bereich der Leistungselektronik 6 auf <110°C gehalten werden kann, womit die Elektronikkomponenten der Leistungselektronik 6 gegen Überhitzung geschützt sind.

Durch die Anordnung der Leistungselektronik 6 an der Gehäusewandung 7 im Aktuatorgehäuse 2 zwischen der Spule 3 und dem axialen Aktuatorende E des Aktuators 1 resultiert folglich eine ausreichende Kühlung der Leistungselektronik 6, weil die im Aktuator 1 erzeugte Wärme über die Gehäusewandung 7 und das axiale Aktuatorende E des Aktuatorgehäuses 2 an das Kompressorgehäuse 20 abgeleitet wird. Die Kühlung des Kompressors 19 kann also in vorteilhafterweise dazu genützt werden, um eine verbesserte Wärmeabfuhr vom Aktuator 1 zu erreichen.

## Patentansprüche

1. Elektromagnetisch betätigbarer Aktuator (1) zur Anordnung an einem Kolbenkompressor (19), zur Betätigung eines Ventils, vorzugsweise eines Saugventils (21) des Kolbenkompressors (19), wobei der Aktuator (1) ein Aktuatorgehäuse (2) aufweist, in dem eine Spule (3) und ein Magnetanker (4) angeordnet sind, wobei der Magnetanker (4) mit der Spule (3) elektromagnetisch zusammenwirkt, um den Magnetanker (4) zu bewegen, wobei der Magnetanker (4) mit einem Betätigungselement (5) zur Betätigung des Ventils verbunden ist, wobei an einem axialen Aktuatorende (E) des Aktuatorgehäuses (2) eine Betätigungsöffnung (5a) für das Betätigungselement (5) vorgesehen ist und wobei der Aktuator (1) von einer Leistungselektronik (6) ansteuerbar ist, **dadurch gekennzeichnet, dass** die Leistungselektronik (6) im Aktuatorgehäuse (2) zwischen der Spule (3) und dem axialen Aktuatorende (E), an dem die Betätigungsöffnung vorgesehen ist, angeordnet ist, wobei die Leistungselektronik (6) durch eine Gehäusewandung (7) des Aktuatorgehäuses (2) von der Spule (3) getrennt ist, wobei eine Leiterplatte (8) der Leistungselektronik (6) an einer an der Gehäusewandung (7) vorgesehenen Befestigungsfläche (9) angeordnet ist, wobei sich elektrische Spulenkontakte (10) der Spule (3) durch die Gehäusewandung (7) hindurch erstrecken und mit der Leiterplatte (8) verbunden sind.

2. Elektromagnetisch betätigbarer Aktuator nach Anspruch 1, **dadurch gekennzeichnet, dass** das Aktuatorgehäuse (2) zumindest im Bereich der Gehäusewandung (7) aus einem wärmeleitfähigen Werkstoff, vorzugsweise Metall, besonders bevorzugt Aluminium hergestellt ist.

3. Elektromagnetisch betätigbarer Aktuator nach Anspruch 1 oder 2, **dadurch gekennzeichnet, dass** zwischen der Befestigungsfläche (9) der Gehäusewandung (7) des Aktuatorgehäuses (2) und der Leiterplatte (8) zumindest ein Wärmeleitelement (11) angeordnet ist.

4. Elektromagnetisch betätigbarer Aktuator nach Anspruch 3, **dadurch gekennzeichnet, dass** das Wärmeleitelement (11) mit der Leiterplatte (8) verbunden ist, vorzugsweise mittels eines wärmeleitenden Klebstoffs oder wärmeleitenden Klebebands.

5. Elektromagnetisch betätigbarer Aktuator nach Anspruch 3 oder 4, **dadurch gekennzeichnet, dass** zumindest temperaturempfindliche elektronische Bauelemente (12), insbesondere Mosfets, der Leiterplatte (8) im Bereich des Wärmeleitelements (11) angeordnet sind.

6. Elektromagnetisch betätigbarer Aktuator nach einem der Ansprüche 1 bis 5, **dadurch gekennzeichnet, dass** die Leistungselektronik (6) zumindest teilweise mit einer wärmeleitfähigen Vergussmasse überzogen ist.

7. Kolbenkompressor (19) mit zumindest einem Ventil, insbesondere Saugventil (21), zur Steuerung eines Medienstroms eines Kompressionsmediums und mit einem Aktuator zur Betätigung des Ventils, wobei der Aktuator als elektromagnetisch betätigbarer Aktuator (1) nach einem der Ansprüche 1 bis 6 ausgeführt ist, wobei das Betätigungselement (5) des Aktuators (1) vorgesehen ist, mit dem Ventil zusammenzuwirken, um das Ventil zu betätigen.

8. Kolbenkompressor (19) nach Anspruch 7, **dadurch gekennzeichnet, dass** ein Kompressorgehäuse (20) des Kolbenkompressors (19) im Bereich des Ventils, vorzugsweise Saugventils (21), von einem Kühlemedium gekühlt ist, wobei der Aktuator (1) am Kompressorgehäuse (20) angeordnet wird, um den Aktuator (1) im Bereich der Leistungselektronik (6) zu kühlen, indem von der Spule (3) erzeugte Wärme über die Gehäusewandung (7) des Aktuatorgehäuses (2) und das axiale Aktuatorende (E) des Aktuators (1) an das Kompressorgehäuse (20) ableitbar ist.

9. Ventilbaugruppe zur Anordnung an einem Kolbenkompressor (19), mit einem Aufnahmegehäuse (22), in dem ein Ventil, insbesondere Saugventil (21), angeordnet ist und mit einem am Aufnahmegehäuse (22) befestigten Aktuator, zur Betätigung des Ventils, wobei der Aktuator als elektromagnetisch betätigbarer Aktuator (1) nach einem der Ansprüche 1 bis 6 ausgeführt ist, wobei das Betätigungselement (5) des Aktuators (1) vorgesehen ist, durch eine im Aufnahmegehäuse (22) angeordnete Öffnung (22a) mit dem Ventil zusammenzuwirken, um das Ventil zu betätigen.
